# DEMANDE DE BREVET EUROPEEN

(11) **EP 4 838 630 A2**
(43) Date de publication de la demande: **11.11.2026**
(21) Numéro de dépôt: 26208422.1
(22) Date de dépôt: 29.09.2026
(51) Int. Cl.: H01M 10/6556, H01M 10/613, H01M 10/647, H01M 10/6554

(54) **DISPOSITIF DE THERMORÉGULATION**

(30) Priorité: 25.03.2026 FR 2603738
(71) Demandeur: Hutchinson, 92110 Clichy (FR)
(72) Inventeur: MORETTI, Nicola, 10090 Rivoli (IT); OLIVA, Gaetana Cristiana, 10090 Rivoli (IT); ROCCA, Fabrizio, 10090 Rivoli (IT); BAGNASCO, Maurizio, 10090 Rivoli (IT); DOMINIAK, Robin, 10090 Rivoli (IT)
(74) Mandataire: Condorcet IP

(57) **Abrégé**

L'invention a pour objet un dispositif de thermorégulation (1) pour un composant à thermoréguler (90), ce composant à thermoréguler (90) étant par exemple un dispositif électronique ou une cellule de batterie, le dispositif (1) comprenant au moins un conduit (104) pour la circulation d'un fluide caloporteur, ledit conduit (104) étant délimité par au moins une paroi souple (2) et étant configuré pour venir en contact avec une paroi du composant à thermoréguler (90), ladite paroi (2) comprenant un film multicouche (10) qui est formé exclusivement d'une pluralité de couches (11) électriquement isolantes, notamment configurées de sorte que ledit film multicouche (10) puisse isoler électriquement le fluide caloporteur de charge électrique provenant d'un élément extérieur (91) adjacent au dispositif (1).

## Description

La présente invention concerne un dispositif de thermorégulation pour un composant à thermoréguler, ce composant étant par exemple un dispositif électronique ou une cellule de batterie. L'invention trouve une application particulièrement avantageuse pour la thermorégulation liquide indirecte des cellules de batteries de véhicules électriques ou des équipements électroniques de serveurs de centres de données (data centers) par exemple.

De manière connue, pour optimiser les performances, prolonger la durée de vie et assurer la sécurité de ces composants, il est courant d'utiliser des dispositifs de refroidissement comprenant au moins un conduit pour la circulation d'un fluide caloporteur, tel qu'un mélange eau-glycol. Afin d'optimiser le transfert de chaleur, ce conduit peut être délimité par une paroi souple apte à se déformer sous l'effet d'une pression interne. Cette déformation permet à la paroi de venir épouser les aspérités du composant à thermoréguler, comblant ainsi les espaces d'air et optimisant le contact thermique.

Pour réaliser ces parois souples, on a recours à des films multicouches intégrant classiquement une couche métallique (par exemple en aluminium) prise en sandwich entre des couches plastiques, afin de garantir à la fois une bonne conductivité thermique et une résistance mécanique. Cependant, la présence d'une couche conductrice métallique présente un risque majeur. Lorsque le dispositif est découpé, les faces périphériques (ou tranches) du film exposent le métal. Si le dispositif de thermorégulation est logé au voisinage d'un élément extérieur soumis à un potentiel électrique, un contact accidentel avec la tranche du film peut propager cette charge électrique jusqu'au fluide caloporteur ou provoquer un claquage diélectrique.

La présente invention a pour but de pallier ces inconvénients.

L'invention a ainsi pour objet un dispositif de thermorégulation pour un composant à thermoréguler, ce composant à thermoréguler étant par exemple un dispositif électronique ou une cellule de batterie, le dispositif comprenant au moins un conduit pour la circulation d'un fluide caloporteur, ledit conduit étant délimité par au moins une paroi souple et étant configuré pour venir en contact avec une paroi du composant à thermoréguler, ladite paroi comprenant un film multicouche qui est formé exclusivement d'une pluralité de couches électriquement isolantes, notamment configurées de sorte que ledit film multicouche puisse isoler électriquement le fluide caloporteur de charge électrique provenant d'un élément extérieur adjacent au dispositif.

Dans le cadre de la présente demande, par l'expression "film multicouche formé exclusivement d'une pluralité de couches électriquement isolantes", il faut entendre que ledit film multicouche est, par exemple, dépourvu de toute couche électriquement conductrice, telle qu'une couche métallique.

Selon l'un des aspects de l'invention, les matières dont chaque couche du film multicouche est formée présentent une résistivité électrique volumique égale ou supérieure à 10¹¹ Ω·cm.

Afin d'assurer une caractérisation fiable et reproductible de la résistivité électrique volumique desdites matières, la détermination de cette résistivité est avantageusement effectuée selon la méthode ASTM D257, dans des conditions d'essai contrôlées comprenant une température de 23 ± 2 °C et une humidité relative de 50 ± 5 %. La tension d'essai appliquée est de 500 V DC et la résistance est déterminée après un temps d'électrification de 60 secondes.

Il est important de soumettre les échantillons à un conditionnement préalable en atmosphère contrôlée, afin d'assurer leur stabilisation hygroscopique et thermique avant la mesure. Ce conditionnement est important car, comme le reconnaît la norme ASTM D257, la résistivité - notamment la résistivité de surface mais également la résistivité de volume - varie sensiblement avec la teneur en humidité du matériau.

Dans le cadre de la présente invention, le conditionnement est avantageusement réalisé à une température de 23 ± 2 °C et une humidité relative de 50 ± 5 %, pendant au moins 40 heures ou, le cas échéant, pendant toute durée suffisante pour permettre au matériau d'atteindre son équilibre hygroscopique, certaines matières, telles que les polyamides, pouvant nécessiter des temps plus longs en raison de leur forte affinité pour l'humidité.

À titre d'exemple, ce conditionnement peut suivre les principes de la pratique ASTM D618, tandis que le maintien d'une humidité relative constante peut être réalisé selon des méthodes telles que celles décrites dans ASTM E104 ou ASTM D5032, sans que l'application d'une norme particulière ne soit impérative dans le cadre de la présente invention : il suffit que le conditionnement soit réalisé dans un environnement à température et humidité stables, de manière à garantir que la résistivité mesurée reflète effectivement les propriétés intrinsèques du matériau, indépendamment de son histoire hydrique ou de fluctuations transitoires de l'environnement.

Dans le cadre de la présente invention, il est entendu que l'échantillon utilisé pour la mesure n'est pas le film de l'épaisseur effective des couches du film multicouche, mais un spécimen d'une épaisseur comprise avantageusement entre 1 et 3 mm, choisi de manière à représenter les propriétés intrinsèques du matériau. Une telle épaisseur permet d'éviter que la résistivité ne soit artificiellement réduite en raison de la diminution excessive de l'épaisseur par rapport à la surface électrodique ou par de phénomènes de claquage localisés, phénomènes susceptibles de se produire lorsque le matériau est testé sous forme de films ultraminces.

L'emploi de spécimens d'épaisseur comprise entre 1 et 3 mm permet également de réduire l'influence des défauts ponctuels, irrégularités locales, inclusions, micro-porosités
ou hétérogénéités superficielles, qui pourraient sinon altérer la reproductibilité ou la représentativité de la mesure. Les dimensions du spécimen assurent ainsi un chemin de courant stable et une évaluation correcte de la résistivité volumique du matériau constituant.

En conséquence, la qualification d'un matériau comme « électriquement isolant » au sens de la présente invention, et notamment la conformité au seuil de 10¹¹ Ω·cm, doit être comprise comme une propriété intrinsèque du matériau évaluée notamment dans les conditions normalisées susmentionnées et sur un échantillon présentant une épaisseur comprise entre 1 et 3 mm, indépendamment de la réduction d'épaisseur des couches dans le film multicouche final.

Selon l'un des aspects de l'invention, la matière de l'une au moins des couches du film multicouche présente une résistivité électrique volumique égale ou supérieure à 10¹³ Ω·cm, de préférence égale ou supérieure à 10¹⁴ Ω·cm.

Selon l'un des aspects de l'invention, le comportement isolant et antistatique des couches est configuré pour empêcher une propagation indésirable de la charge électrique à l'intérieur de chaque couche en cas de contact de ses faces périphériques avec des composants soumis à un potentiel VE différent par rapport au potentiel VC de la couche.

Selon l'un des aspects de l'invention, le film multicouche comprend au moins deux couches, ou au moins trois couches ou au moins quatre couches électriquement isolantes empilées.

Selon l'un des aspects de l'invention, l'épaisseur totale du film multicouche est comprise entre 100 et 200 micromètres.

Selon l'un des aspects de l'invention, l'épaisseur totale du film multicouche est comprise entre 120 et 180 micromètres, de préférence entre 140 et 160 micromètres.

Selon l'un des aspects de l'invention, la répartition des épaisseurs des couches du film multicouche est uniforme.

En variante, la répartition des épaisseurs des couches est non uniforme, au moins une couche présentant une épaisseur différente des autres couches.

Selon l'un des aspects de l'invention, toutes les couches électriquement isolantes du film multicouche sont réalisées en matière plastique, lesdites matières plastiques étant choisies par exemple parmi : le PET (Polytéréphtalate d'éthylène), le PE (Polyéthylène), une PA (Polyamides, tels que PA6, PA11, PA12, PA66), le PP (Polypropylène) ou le PBT (Polytéréphtalate de butylène).

Selon l'un des aspects de l'invention, les matières polymères de chaque couche sont différentes d'une couche à l'autre.

Selon l'un des aspects de l'invention, les matières polymères d'au moins deux couches du film multicouche sont identiques.

Selon l'un des aspects de l'invention, l'une au moins des couches du film multicouche incorpore des charges augmentant la conductivité thermique et notamment sans réduire la résistivité électrique.

Selon l'un des aspects de l'invention, les charges augmentant la conductivité thermique comprennent une ou plusieurs charges choisies parmi : un nitrure, l'oxyde d'aluminium, l'oxyde de magnésium, et l'hydroxyde d'aluminium.

Par exemple, lesdites charges augmentant la conductivité thermique comprennent du nitrure de bore.

Selon l'un des aspects de l'invention, la teneur desdites charges thermiquement conductrices est comprise entre 1 et 50 % en poids, par exemple entre 10 et 40 % en poids, notamment entre 20 et 30 % en poids.

Selon l'un des aspects de l'invention, le film multicouche est agencé sous forme de feuille présentant deux faces étendues parallèles entre elles et une pluralité de faces périphériques sensiblement perpendiculaires aux faces étendues.

Les faces périphériques définissent des tranches du film multicouche.

Selon l'un des aspects de l'invention, le conduit du dispositif est réalisé par au moins deux feuilles formées chacune d'un film multicouche tel que décrit ci-dessus, et notamment soudées ou collées entre elles, en définissant des régions d'adhésion et des régions de séparation.

Selon l'un des aspects de l'invention, le film multicouche, par exemple issu d'un rouleau de film multicouche, peut être découpé aux dimensions prédéterminées pour former une feuille. La feuille peut être pliée et soudée sur elle-même, ou soudée à une autre feuille, ou soudée sur un composant rigide, formant ainsi le conduit du dispositif de thermorégulation.

Dans un exemple de réalisation de l'invention, la paroi souple peut ainsi être réalisée par une seule feuille.

Le conduit du dispositif de thermorégulation peut être délimité par exemple par une seule paroi souple (par exemple collée ou soudée sur un composant rigide pour définir un volume à contour fermé du conduit), ou par deux parois (formées d'une seule feuille pliée ou de deux feuilles par exemple) qui définissent un volume à contour fermé du conduit.

Selon l'un des aspects de l'invention, lesdites régions d'adhésion et de séparation définissent ledit au moins un conduit mettant en communication de fluide une ou plusieurs portions d'entrée avec une ou plusieurs portions de sortie du conduit.

Selon l'un des aspects de l'invention, le dispositif comprend en outre un organe rigide, tel qu'une plaque ou un cadre, ladite paroi souple étant soudée ou collée sur cet organe rigide.

Selon l'un des aspects de l'invention, l'organe rigide intègre des connectiques formant une entrée et une sortie pour le fluide caloporteur.

Selon l'un des aspects de l'invention, les connectiques d'entrée et de sortie du fluide sont intégrées et soudées directement sur une face étendue de la feuille.

Selon l'un des aspects de l'invention, le film multicouche comprend une couche interne, c'est-à-dire en contact avec le fluide caloporteur, électriquement isolante présentant une compatibilité chimique avec le fluide caloporteur et apte à être soudée à chaud.

Selon l'un des aspects de l'invention, le film multicouche comprend une couche externe électriquement isolante configurée pour assurer une protection mécanique et anti-corrosion du dispositif.

Selon l'un des aspects de l'invention, le fluide caloporteur destiné à circuler dans le conduit comprend un mélange eau-glycol.

Selon l'un des aspects de l'invention, le dispositif est configuré pour assurer une thermorégulation liquide indirecte, ladite paroi souple étant apte à se déformer sous l'effet d'une pression interne afin d'optimiser le contact thermique en comblant les aspérités de la paroi du composant à thermoréguler.

L'invention concerne encore un système de gestion thermique comprenant au moins un composant à thermoréguler, tel qu'une cellule de batterie de véhicule électrique ou un équipement électronique de serveur de centre de données (data center), et un dispositif de thermorégulation pour un composant à thermoréguler tel que précité, ledit dispositif étant disposé de manière à ce que ladite paroi souple soit en contact thermique avec ledit composant à thermoréguler.

Selon l'un des aspects de l'invention, le composant à thermoréguler est logé au voisinage, voire en contact, d'une enceinte ou d'un élément susceptible d'être soumis à un potentiel électrique VE, le film multicouche étant configuré pour empêcher la mise au potentiel VE d'une de ses couches ou du fluide caloporteur et protégeant le dispositif d'un claquage diélectrique.

L'invention concerne encore un procédé de fabrication d'un dispositif de thermorégulation pour un composant à thermoréguler tel que précité, comprenant les étapes suivantes :
- la fourniture d'un film multicouche formé exclusivement d'une pluralité de couches polymériques électriquement isolantes ;
- la découpe d'au moins une feuille dudit film multicouche aux dimensions prédéterminées pour la réalisation d'au moins une paroi souple d'un conduit du dispositif de thermorégulation ;
- optionnellement, la fourniture d'une deuxième feuille découpée aux dimensions prédéterminées pour la réalisation d'une deuxième paroi souple dudit conduit, ou la fourniture d'un composant rigide d'entrée/sortie du fluide caloporteur ;
- la fermeture de ladite paroi souple notamment par soudure à chaud ou collage sur elle-même, ou, en présence desdits composants optionnels, sur la deuxième paroi souple optionnelle ou sur le composant rigide optionnel, en définissant des régions d'adhésion et des régions de séparation pour former le conduit ;
- optionnellement, la mise en forme de ladite paroi souple ou, le cas échéant, desdites parois souples du conduit.

Selon l'un des aspects de l'invention, l'étape de soudure à chaud ou collage est réalisée pour assembler la couche interne du film multicouche sur elle-même ou sur les bords d'un composant rigide d'entrée/sortie de fluide caloporteur.

L'invention concerne encore un dispositif de thermorégulation pour un composant à thermoréguler, ce composant à thermoréguler étant un dispositif électronique ou une cellule de batterie, le dispositif comprenant au moins un conduit pour la circulation d'un fluide caloporteur, ledit conduit étant délimité par au moins une paroi souple et étant configuré pour venir en contact avec une paroi du composant à thermoréguler, ladite paroi comprenant un film multicouche, caractérisé par le fait que ledit film présente une résistance électrique telle qu'elle maintient électriquement isolée une première portion du film d'une seconde portion de celui-ci lorsqu'un potentiel VE est appliqué à une face périphérique ou à une face étendue dudit film, dans lequel ladite isolation est maintenue dans une plage d'humidité relative comprise entre 10% et 80%.

L'invention présente de multiples avantages.

En utilisant un film multicouche formé exclusivement de couches électriquement isolantes (et donc totalement dépourvu de couche métallique conductrice ou de toute couche métallisée), le dispositif empêche toute propagation indésirable d'une charge électrique depuis un élément extérieur vers le fluide caloporteur. Cela protège efficacement contre les risques de claquage diélectrique.

Les matériaux utilisés pour les couches présentent une très haute résistivité électrique volumique. Cette propriété permet de maintenir une portion du film électriquement isolée d'une autre portion, et ce de manière stable même dans une large plage d'humidité relative comprise entre 10% et 80%.

L'absence de métal n'entrave pas sensiblement le refroidissement. Les couches plastiques peuvent incorporer des charges spécifiques (comme des nitrures, de l'oxyde d'aluminium, de l'hydroxyde d'aluminium ou du nitrure de bore). Ces charges permettent d'augmenter significativement la conductivité thermique de la paroi souple sans réduire sa résistivité électrique.

L'épaisseur du film multicouche ainsi que l'utilisation de polymères tels que le PET, le PE, le PP, les PA ou le PBT, permettent de conserver une excellente flexibilité. La paroi souple peut ainsi se déformer de manière optimale sous la pression interne du fluide (tel qu'un mélange eau-glycol) pour épouser la surface du composant.

D'autres caractéristiques, détails et avantages de l'invention ressortiront plus clairement à la lecture de la description qui suit d'une part, et d'un exemple de réalisation donné à titre indicatif et non limitatif en référence aux dessins schématiques annexés d'autre part, sur lesquels :
[Fig. 1] La figure 1 représente schématiquement et partiellement une vue en coupe, d'un dispositif de thermorégulation selon un premier mode de réalisation de l'invention ;
[Fig. 2] La figure 2 représente schématiquement un film multicouche agencé sous forme d'une feuille, illustrant notamment ses faces étendues et ses faces périphériques définissant les tranches du film ;
[Fig. 3] La figure 3 représente schématiquement et partiellement une vue en coupe, d'un dispositif de thermorégulation selon un deuxième mode de réalisation de l'invention.

Les caractéristiques, variantes et les différentes formes de réalisation de l'invention peuvent être associées les unes avec les autres, selon diverses combinaisons, dans la mesure où elles ne sont pas incompatibles ou exclusives les unes par rapport aux autres. On pourra notamment imaginer des variantes de l'invention ne comprenant qu'une sélection de caractéristiques décrites par la suite de manière isolée des autres caractéristiques décrites, si cette sélection de caractéristiques est suffisante pour conférer un avantage technique et/ou pour différencier l'invention par rapport à l'état de la technique antérieur.

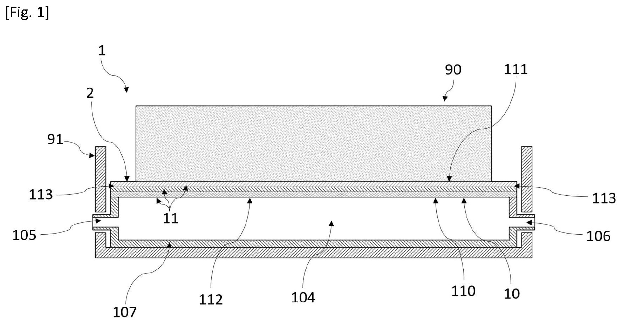

On a décrit sur la figure 1 un dispositif de thermorégulation 1 pour un composant à thermoréguler 90, ce composant étant par exemple un dispositif électronique ou une cellule de batterie.

L'invention trouve une application par exemple dans le domaine automobile, notamment pour la thermorégulation liquide indirecte des cellules de batteries de véhicules électriques, ou dans des équipements électroniques de serveurs de centres de données.

Le dispositif de thermorégulation 1 comprend au moins un conduit 104 pour la circulation d'un fluide caloporteur.

Ce fluide caloporteur destiné à circuler dans le conduit 104 comprend notamment un mélange eau-glycol.

Le conduit 104 est délimité par au moins une paroi souple 2 apte à se déformer sous l'effet d'une pression interne du fluide caloporteur. Cette déformation permet à la paroi 2 de venir épouser la forme du composant à thermoréguler 90, comblant ainsi les espaces d'air et optimisant le contact thermique.

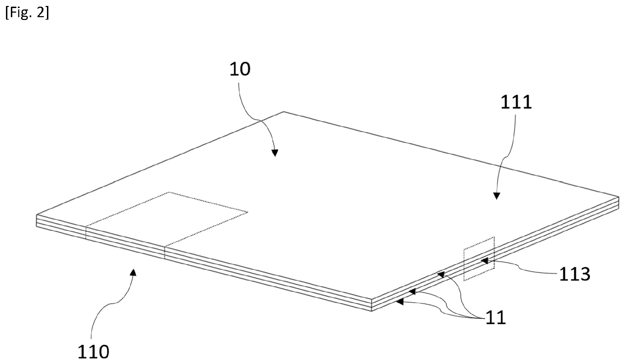

La paroi souple 2 est réalisée à partir d'un film multicouche 10 agencé sous forme d'une feuille 110. Cette feuille 110 présente deux faces étendues 111, 112 parallèles entre elles et une pluralité de faces périphériques 113 sensiblement perpendiculaires aux faces étendues. Les faces périphériques 113 définissent des tranches du film multicouche 10, comme illustré sur la figure 2.

Le conduit 104 met en communication de fluide une ou plusieurs portions d'entrée 105 avec une ou plusieurs portions de sortie 106 du conduit.

La figure 1 illustre un premier mode de réalisation de l'invention. Dans cette configuration, le dispositif de thermorégulation 1 comprend un organe rigide 107, tel qu'une plaque, ladite paroi souple 2 étant soudée ou collée sur cet organe rigide 107.

Le conduit 104 est défini par des régions d'adhésion et de séparation entre la feuille 110 et le composant rigide 107.

L'organe rigide 107 intègre des connectiques formant une entrée 105 et une sortie 106 pour le fluide caloporteur.

Les portions d'entrée 105 et de sortie 106 peuvent se présenter sous la forme d'embouts tubulaires. Ces embouts permettent le raccordement étanche du dispositif de thermorégulation au reste du circuit externe de circulation du fluide caloporteur.

Lors de sa circulation dans le dispositif de thermorégulation 1, le fluide est en contact avec la feuille 110. Cette feuille 110 est un film multicouche 10 électriquement isolant et totalement dépourvu de couche métallique conductrice.

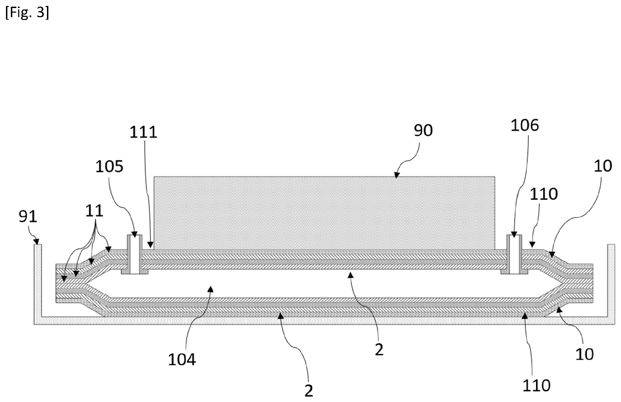

La figure 3 illustre un deuxième mode de réalisation de l'invention, avec deux parois souples 2 réalisées chacune par une feuille 110 formée d'un film multicouche 10, et les feuilles 110 sont soudées ou collées entre elles, en définissant des régions d'adhésion et des régions de séparation. Ces régions d'adhésion et de séparation définissent ledit au moins un conduit 104 mettant en communication de fluide la portion d'entrée 105 avec la portion de sortie 106.

Dans cette variante, les connectiques d'entrée 105 et de sortie 106 du fluide sont intégrées et soudées directement sur une face étendue 111 d'une des feuilles.

Le composant à thermoréguler 90 est disposé de manière à ce que la paroi souple 2 soit en contact thermique avec lui, reposant par exemple sur la face étendue 111.

Pour les modes de réalisation de l'invention décrits ci-dessus, le film multicouche 10 est formé exclusivement d'une pluralité de couches électriquement isolantes 11 empilées. Le film multicouche 10 est dépourvu de toute couche électriquement conductrice, telle qu'une couche métallique.

L'invention permet au film multicouche 10 d'isoler électriquement le fluide caloporteur d'une charge électrique provenant d'un élément extérieur 91 adjacent au dispositif de thermorégulation 1. Cet élément extérieur 91 adjacent correspond, par exemple, à une paroi d'un autre composant du système ou à une structure de l'enceinte qui contient le composant à thermoréguler.

Cela protège efficacement le dispositif contre les risques de claquage diélectrique.

Les matières plastiques des couches 11, comprenant par exemple du PET, du PE, du PP, des PA ou du PBT, présentent une résistivité électrique volumique égale ou supérieure à 10¹¹ Ω·cm. De préférence, la matière de l'une au moins des couches 11 du film multicouche 10 présente une résistivité électrique volumique égale ou supérieure à 10¹³ Ω·cm, voire 10¹⁴ Ω·cm.

Ce comportement isolant et antistatique empêche une propagation indésirable de la charge électrique à l'intérieur de chaque couche 11 en cas de contact de ses faces périphériques 113 avec des composants soumis à un potentiel différent.

Le film multicouche 10 comprend au moins deux couches, ou au moins trois couches, ou au moins quatre couches 11 électriquement isolantes empilées.

Ainsi, dans le cadre du premier mode de réalisation illustré par la figure 1, le film multicouche 10 comprend trois couches 11 empilées.

Dans le second mode de réalisation illustré par la figure 3, le conduit 104 est formé de deux films multicouches 10 comprenant chacun quatre couches 11 électriquement isolantes.

Notamment le film multicouche 10 comprend une couche interne 11, en contact avec le fluide caloporteur, électriquement isolante présentant une compatibilité chimique avec le fluide caloporteur et apte à être soudée à chaud. Il comprend également une couche externe 11 électriquement isolante configurée pour assurer une protection mécanique et anti-corrosion du dispositif.

L'épaisseur totale du film multicouche 10 est comprise entre 100 et 200 micromètres, et de préférence entre 120 et 180 micromètres.

Cette épaisseur, associée aux polymères choisis, permet de conserver une flexibilité adaptée.

L'une au moins des couches 11 du film multicouche 10 peut incorporer des charges augmentant la conductivité thermique sans réduire la résistivité électrique. Ces charges augmentant la conductivité thermique, dont la teneur est comprise par exemple entre 1 et 50 % en poids, comprennent une ou plusieurs charges choisies dans le groupe comprenant les nitrures, le nitrure de bore, l'oxyde d'aluminium, l'oxyde de magnésium, et l'hydroxyde d'aluminium.

Le conduit 104 du dispositif de thermorégulation peut être délimité par exemple par une seule paroi souple (par exemple collée ou soudée sur un composant rigide pour définir un volume à contour fermé du conduit) comme illustré sur la figure 1, ou par deux parois souples (formées d'une seule feuille pliée ou de deux feuilles par exemple) qui définissent un volume à contour fermé du conduit, comme illustré sur la figure 3.

## Revendications

1. Dispositif de thermorégulation (1) pour un composant à thermoréguler (90), ce composant à thermoréguler (90) étant par exemple un dispositif électronique ou une cellule de batterie, le dispositif (1) comprenant au moins un conduit (104) pour la circulation d'un fluide caloporteur, ledit conduit (104) étant délimité par au moins une paroi souple (2) et étant configuré pour venir en contact avec une paroi du composant à thermoréguler (90), ladite paroi (2) comprenant un film multicouche (10) qui est formé exclusivement d'une pluralité de couches (11) électriquement isolantes, notamment configurées de sorte que ledit film multicouche (10) puisse isoler électriquement le fluide caloporteur de charge électrique provenant d'un élément extérieur (91) adjacent au dispositif (1).

2. Dispositif (1) selon la revendication 1, dans lequel les matières dont chaque couche (11) du film multicouche (10) est formée présentent une résistivité électrique volumique égale ou supérieure à 10¹¹ Ω·cm, mesurée selon la méthode ASTM D257, à une tension d'essai de 500 V DC, après un temps d'électrification de 60 secondes, et sous des conditions contrôlées de 23 ± 2 °C et 50 ± 5 % d'humidité relative.

3. Dispositif (1) selon la revendication 1 ou 2, dans lequel la matière de l'une au moins des couches (11) du film multicouche (10) présente une résistivité électrique volumique égale ou supérieure à 10¹³ Ω·cm, de préférence égale ou supérieure à 10¹⁴ Ω·cm, mesurée selon la méthode ASTM D257, à une tension d'essai de 500 V DC, après un temps d'électrification de 60 secondes, et sous des conditions contrôlées de 23 ± 2 °C et 50 ± 5 % d'humidité relative.

4. Dispositif (1) selon l'une quelconque des revendications précédentes, dans lequel le film multicouche (10) comprend au moins deux couches, ou au moins trois couches ou au moins quatre couches (11) électriquement isolantes empilées.

5. Dispositif (1) selon l'une quelconque des revendications précédentes, dans lequel l'épaisseur totale du film multicouche (10) est comprise entre 100 et 200 micromètres, de préférence entre 120 et 180 micromètres, et notamment entre 140 et 160 micromètres.

6. Dispositif (1) selon l'une quelconque des revendications précédentes, dans lequel toutes les couches (11) électriquement isolantes du film multicouche (10) sont réalisées en matière plastique.

7. Dispositif (1) selon la revendication 6, dans lequel lesdites matières plastiques sont choisies parmi : le PET (Polytéréphtalate d'éthylène), le PE (Polyéthylène), une PA (Polyamide), le PP (Polypropylène) ou le PBT (Polytéréphtalate de butylène).

8. Dispositif (1) selon l'une quelconque des revendications précédentes, dans lequel l'une au moins des couches (11) du film multicouche (10) incorpore des charges augmentant la conductivité thermique.

9. Dispositif (1) selon la revendication 8, dans lequel lesdites charges comprennent une ou plusieurs charges choisies parmi : un nitrure, l'oxyde d'aluminium, l'oxyde de magnésium, l'hydroxyde d'aluminium, la teneur desdites charges étant comprise entre 1 et 50 % en poids.

10. Dispositif (1) selon l'une quelconque des revendications précédentes, dans lequel le film multicouche (10) est agencé sous forme de feuille (110) présentant deux faces étendues (111, 112) parallèles entre elles et une pluralité de faces périphériques (113) sensiblement perpendiculaires aux faces étendues, lesdites faces périphériques (113) définissant des tranches du film multicouche (10).

11. Dispositif (1) selon l'une quelconque des revendications précédentes, dans lequel le conduit (104) est réalisé par au moins deux feuilles (110) formées chacune d'un film multicouche (10), et notamment soudées ou collées entre elles, en définissant des régions d'adhésion et des régions de séparation , lesdites régions d'adhésion et de séparation définissant ledit au moins un conduit (104) mettant en communication de fluide une ou plusieurs portions d'entrée (105) avec une ou plusieurs portions de sortie (106) du conduit.

12. Dispositif (1) selon l'une quelconque des revendications 1 à 10, comprenant en outre un organe rigide (107), tel qu'une plaque ou un cadre, ladite paroi souple (2) étant soudée ou collée sur cet organe rigide (107), l'organe rigide (107) intégrant optionnellement des connectiques formant une entrée (105) et une sortie (106) pour le fluide caloporteur.

13. Dispositif (1) selon l'une quelconque des revendications précédentes, dans lequel le film multicouche (10) comprend une couche interne (11) électriquement isolante présentant une compatibilité chimique avec le fluide caloporteur et apte à être soudée à chaud, et/ou une couche externe (11) électriquement isolante configurée pour assurer une protection mécanique et anti-corrosion du dispositif.

14. Système de gestion thermique comprenant au moins un composant à thermoréguler (90), tel qu'une cellule de batterie de véhicule électrique ou un équipement électronique de serveur de centre de données (data center), et un dispositif de thermorégulation (1) pour un composant à thermoréguler (90) selon l'une quelconque des revendications 1 à 13, ledit dispositif (1) étant disposé de manière à ce que ladite paroi souple (2) soit en contact thermique avec ledit composant à thermoréguler (90).

15. Procédé de fabrication d'un dispositif de thermorégulation (1) pour un composant à thermoréguler (90) selon l'une quelconque des revendications 1 à 13, comprenant les étapes suivantes :
- la fourniture d'un film multicouche (10) formé exclusivement d'une pluralité de couches (11) polymériques électriquement isolantes ;
- la découpe d'au moins une feuille (110) dudit film multicouche (10) aux dimensions prédéterminées pour la réalisation d'au moins une paroi souple (2) d'un conduit (104) du dispositif de thermorégulation ;
- optionnellement, la fourniture d'une deuxième feuille découpée aux dimensions prédéterminées pour la réalisation d'une deuxième paroi souple dudit conduit, ou la fourniture d'un composant rigide d'entrée/sortie (107) du fluide caloporteur ;
- la fermeture de ladite paroi souple (2) notamment par soudure à chaud ou collage sur elle-même, ou, en présence desdits composants optionnels, sur la deuxième paroi souple optionnelle ou sur le composant rigide optionnel (107), en définissant des régions d'adhésion et des régions de séparation pour former le conduit (104) ;
- optionnellement, la mise en forme de ladite paroi souple ou, le cas échéant, desdites parois souples (2) du conduit.
